# EUROPEAN PATENT APPLICATION

(11) **EP 1 306 904 A2**
(43) Date of publication of application: **02.05.2003**
(21) Application number: 02025480.1
(22) Date of filing: 05.09.1997
(51) Int. Cl.: H01L 29/772, H01L 45/00, H01L 29/788, H01L 29/786

(54) **Controlled conduction device**

(62) Divisional of application: 97306916.4
(71) Applicant: HITACHI EUROPE LIMITED, Maidenhead, Berkshire, SL6 8YA (GB)
(72) Inventor: Nakazato, Kazuo, Cambridge, CB2 2RP (GB); Mizuta, Hiroshi, Milton, Cambridge CB4 6DS (GB); Shimada, Toshikazu, Kokubunji, Tokyo 185 (JP); Sunami, Hideo, Tokyo 190-01 (JP); Itoh, Kiyoo, Higashi-Kurume, Tokyo 203 (JP); Teshima, Tatsuya, Sagamihara, Kanagawa 228 (JP); Mine, Toshiyuki, Tokyo (JP)
(74) Representative: Read, Matthew Charles

(57) **Abstract**

A controllable conduction device comprises an upstanding pillar structure (20) having a side wall (22) and a top surface (21), the structure being formed of regions (6, 7) of relatively conductive and non-conductive material such that in a first condition, charge carrier flow can occur through the pillar structure and in a second condition the regions present a tunnel barrier configuration that inhibits charge carrier flow, and a side gate (23) structure alongside the side wall (22) of the pillar structure, configured to apply an electric field through the side wall into the pillar structure to control charge carrier transport. The device can be used as a memory with a memory node (10) beneath the pillar structure, which stores charge that passes from a control electrode (11) on the top surface (21) of the pillar structure. The device can also be configured as a transistor with a source (5) on top of the pillar and a drain (2) underlying it.

## Description

This invention relates to a controllable conduction device for use in a memory or a transistor structure.

In EP-A-0843360, (Art 54(3) EPC) there is described a memory device which includes a memory node to which charge is written through a tunnel barrier configuration from a control electrode. The stored charge affects the conductivity of a source-drain path and data is read by monitoring the conductivity of the path. The charge barrier configuration comprises a multiple tunnel barrier which may comprise alternating layers of polysilicon of 5nm thickness and layers of silicon nitride of 2nm thickness, overlying a polycrystalline layer of silicon, part of which acts as a memory node. Alternative barrier configurations are described including conductive nanometre scale conductive islands which act as a memory node, distributed in an insulating matrix. The advantage of the tunnel barrier configuration is that it reduces leakage current from the memory node without degrading the reading and writing times for the memory. Different types of memory device are described. In a first type, charge carriers from a control electrode pass through the tunnel barrier configuration to the memory node in response to a voltage applied to the control electrode. In a second type of device, an additional gate is provided for the tunnel barrier configuration in order to control the transfer of charge carriers from the control electrode to the memory node.

The charge barrier configuration can also be used in a controlled conduction device such as a transistor, as described in EP-A-0892440 (Art 54(3) EPC). The tunnel barrier configuration is used to provide a conductive path between a source and drain. When switched on, charge carriers can flow between the source and drain, but when switched off, the barrier configuration inhibits charge leakage through the path. A large on/off current ratio is thus obtained.

The present invention relates to a number of inventive improvements and modifications to the aforementioned devices.

Considering the second type of memory device disclosed in EP-A-0843360 ***supra***, the tunnel barrier configuration is arranged as an upstanding pillar, with the control electrode overlying it. The additional gate applies an electrostatic field, primarily from above, downwardly through the pillar structure in order to write charge onto the memory node. The configuration of the gate of the transistor disclosed in EP-A-0892440 ***supra*** is configured in a similar way, so as to apply an electrostatic field downwardly into the pillar structure. In this configuration, a high electric field is applied between the gate and the memory node in the case of the memory device, or between the gate and the drain, in the case of the transistor. This high electric field causes electron-hole pairs to be produced, and an accumulation of carriers near the gate structure, which screens the confinement potential.

In order to overcome these problems, the invention in a first aspect provides a controllable conduction device as claimed in claim 1. Further features and advantages of the invention will be apparent from the subsidiary claims 2 to 13.

One embodiment of the memory device described in EP-A-0843361 ***supra*** is non-volatile. The barrier configuration includes an insulating silicon nitride barrier of 5nm thickness disposed between non-doped silicon layers of 30 nm thickness. The resulting energy band profile is such that charge stored on the memory node is retained by the resulting barrier configuration when no control voltages are applied to the memory device.

The present invention also provides an improved non-volatile configuration. According to the invention as claimed in claim 14, a control electrode may be included for supplying charge carriers to the path so as to pass through the structure to be stored at the node, wherein the regions of non-conductive material are configured so as to provide an energy band profile that comprises dimensionally relatively narrow barrier components adjacent the memory node and the control electrode respectively, and a dimensionally relatively wide barrier component between the narrow barrier components, the barrier components being configured such as to provide non-volatile charge storage at the node.

In accordance with another aspect of the invention there is provided a memory device as claimed in claim 16.

In accordance with another aspect of the invention there is provided a memory device as claimed in claim 20.

In order that the invention may be more fully understood, embodiments thereof will now be described by way of example with reference to the accompanying drawings, in which:
Figure 1 is a schematic cross section of a prior transistor structure;
Figure 2a and 2b are energy diagrams for the transistor shown in Figure 1 under different bias conditions;
Figure 3 is a cross section of a prior memory device;
Figure 4a illustrates a transistor device in accordance with the invention, in schematic cross section;
Figure 4b illustrates a memory device in accordance with the invention, in schematic cross section;
Figure 5 illustrates an energy band diagram for the devices shown in Figure 4a and 4b;
Figure 6a is a schematic plan view of a transistor device in accordance with the invention;
Figure 6b is a schematic sectional view of the transistor device of Figure 6a, taken along the line I-I';
Figures 7a - h illustrate the various fabrication steps for manufacturing the transistor device shown in Figure 6;
Figure 8 illustrates a modified pillar structure for use in a device in accordance with the invention;
Figure 9 is an energy band diagram for the device shown in Figure 8;
Figure 10 illustrates a further pillar structure for use in a device according to the invention;
Figure 11 illustrates an energy band diagram for the device shown in Figure 10;
Figure 12 illustrates a further pillar structure for use in a device according to the invention;
Figure 13 illustrates the energy band diagram for the device of Figure 12;
Figure 14 illustrates a further embodiment of a pillar for use in a device according to the invention;
Figure 15 illustrates the energy band diagram for the device of Figure 14;
Figure 16 illustrates an alternative pillar structure for use in a device according to the invention;
Figure 17 illustrates yet a further embodiment of pillar structure for use in a device according to the invention, which incorporates a junction diode side gate;
Figure 18 illustrates the energy band diagram for the device of Figure 17;
Figure 19 illustrates a side gated structure utilising a Schottky gate;
Figure 20 illustrates the energy band diagram for the device of Figure 19;
Figure 21a - 1 illustrate the process steps for manufacturing another embodiment of transistor device in accordance with the invention;
Figure 22 illustrates the transistor device manufactured according to Figure 21, in plan view, with Figure 211 being a section on the line II-II'
Figure 23 is a plan view of a lateral transistor structure according to the invention; and
Figure 24 is a sectional view of the transistor of Figure 23, taken along the line III-III'.

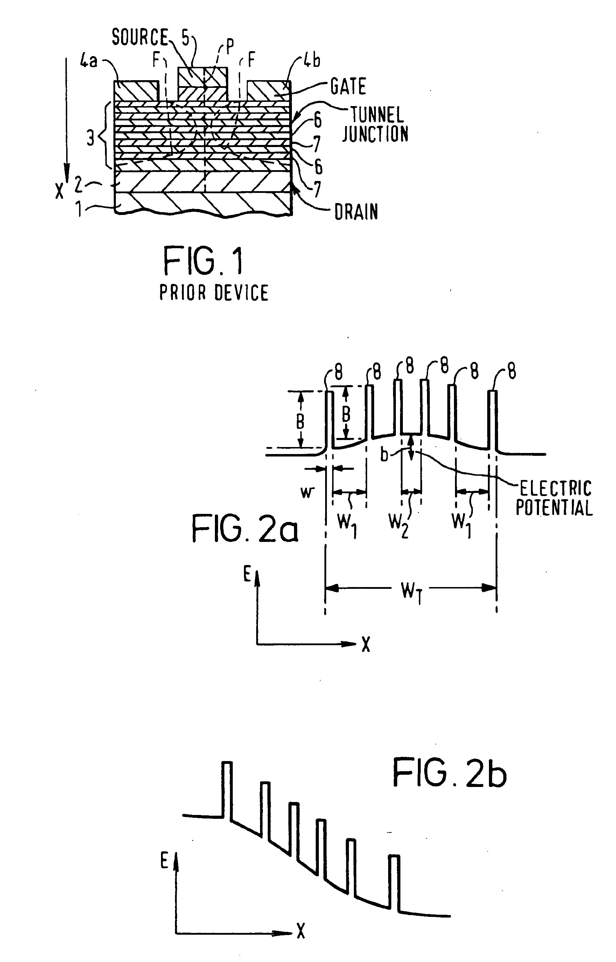

Figure 1 illustrates in section an example of a transistor device described in EP-A-0892440 ***supra***. The device comprises a substrate 1, with a drain region 2 comprising a layer of n-doped polysilicon, overlaid by a multiple layer structure 3 that gives rise to a multiple tunnel junction configuration. The layer structure 3 comprises alternate layers of relatively conducting and non-conducting material such a layers of polysilicon and silicon nitride. The multiple layer structure 3 is overlaid by gate regions 4a, 4b and a source region 5 is disposed between the gate regions. The source and gate regions 4, 5 may comprise n-doped polysilicon. In use, current flows along a path P from the drain 2 to the source 5, transversely of the planes of the layers in the structure. The voltage applied to the gate 4a, b controls the drain/source current.

Referring to the multiple layer structure 3, it comprises conductive, polysilicon layers 6 disposed between layers 7 of electrically insulating, silicon nitride material. The insulating layers 7 are typically of the order of 3nm in thickness and give rise to an energy band diagram as shown in Figure 2a. The insulating layers 7 give rise to relatively high barriers 8 of height *B*, of a relatively narrow width dimension *w* corresponding to the width of the individual layers 7. In this example, the width dimension *w* is of the order of 3nm.

The spacing of the individual barriers 8 is determined by the thicknesses of the layers 6 of the conductive silicon material. Towards the top and bottom of the layer structure 3, the layers 6 have a thickness *W*_{*1*} of the order of 50nm and in the central region of the stack, the layers 6 have a thickness *W*_{*2*} of the order of 5nm.

Collectively, the layers of the structure 3 give rise to a barrier height *b* which is relatively low compared to the barrier height *B* of the individual layers, but which is relatively wide in terms of its physical dimension, corresponding to a width *W*_{*T*} of the entire multiple layer structure 3.

When a source-drain voltage is applied to the device, the energy diagram for the multiple layer structure 3 adopts the configuration shown in Figure 2b. It will be seen that electrons can pass from the source 5 to the drain 2, tunnelling through the relatively narrow barriers *w* falling down the potential gradient provided by the source-drain voltage.

In the configuration shown in Figure 2a, when the source-drain voltage is zero, the relatively wide, but low barrier *b* presented by the layer structure 3 collectively, together with the relatively high but narrow barriers 8 of height *B*, gives rise to a barrier configuration which inhibits charge carrier conduction between the drain and source 2, 5. The wide barrier *b* inhibits electron tunnelling between the source and drain and furthermore, the individual, spaced apart barriers 8 give rise to electron traps that inhibit macroscopic quantum tunnelling. The fact that the barriers at the top and bottom of the stack are spaced by a distance *W*_{*1*}, wider than the spacing *W*_{*2*} of the inner layers of the stack, contributes to the height *b* of the wide barrier.

When a source-drain voltage is applied, conduction occurs from the drain to the source in the manner of a conventional transistor and a conventional current flows consisting of ∼ 10¹³ of electrons per second. Conduction along the path can be controlled by applying a gate voltage to the gate 4 which gives rise to an electrostatic field which "pinches" the width of the conduction path P between the source and the drain, by an amount dependent on the gate voltage. A problem with this arrangement is however, that a relatively high electric field is applied directly between gate 4 and drain 2. This high electric field causes electric field induced electron-hole pairs to be created, and the accumulation of carriers near the gate 4 screens the confinement potential.

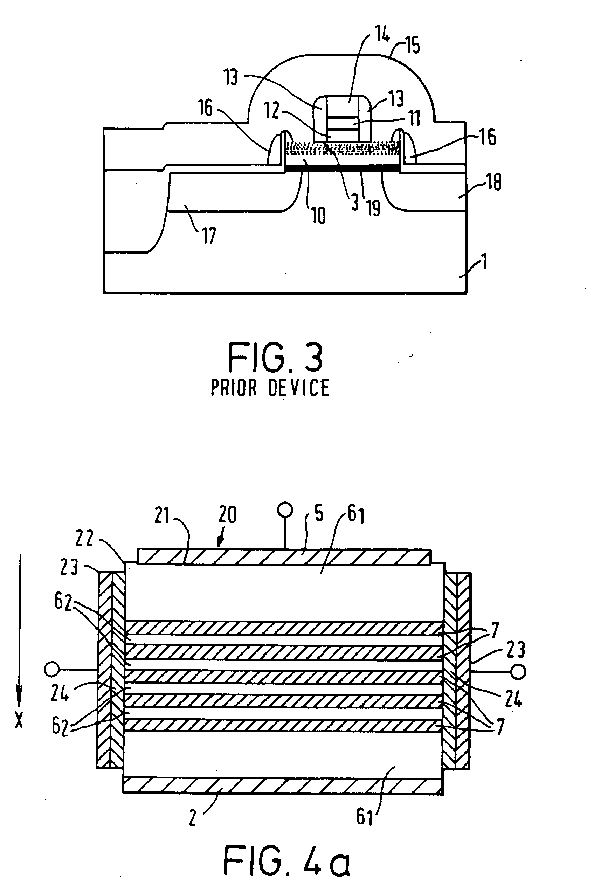

An embodiment of memory device corresponding to Figure 29 of EP-A-0843361 ***supra*** will now be described with reference to Figure 3 herein. The memory device is shown in cross section and is formed in a silicon substrate 1. The device includes a memory node 10 in the form of a polysilicon layer of 5nm, which is overlaid by a layer structure 3, generally the same as that shown in Figure 1, which provides the multiple tunnel barrier configuration. The layer structure 3 is made up of alternate layers of silicon and silicon nitride in the manner previously described. Charge carriers can be written onto the memory node 10 through the layer structure 3 from a control electrode in the form of a 30nm thickness layer 11 of n-type silicon. The control electrode 11 is formed over a conductive layer 12 of intrinsic silicon of 30nm thickness. The control electrode 11 is encapsulated in electrically insulating silicon dioxide layers 13, and 14.

A gate electrode 15 of polysilicon material overlies the layer structure 3 so as to apply an electrostatic field primarily downwardly into the layer structure, so as to allow the potential barrier structure provided by the layers 3 to be selectively raised and lowered, to permit charge to be selectively written onto the memory node 10. The polysilicon gate 15 is electrically insulated form the control electrode 11 by the silicon dioxide layers 13 and 14. Also, the gate 15 is insulated from side edges of the layer structure 3 by a thick oxide layer 16. No significant field from the gate 15 enters through the side edge of layer structure 3, and the conduction controlling field enters downwardly through the uppermost surface of the layer structure.

The memory node 10 acts as a field effect gate for controlling current flow between a source 17 and a drain 18 implanted in the substrate by conventional doping techniques. A conductive path 19 extends between the source and drain 17, 18 and the conductivity varies depending on the level of charge stored on the memory node 10. The use of the multiple layer structure 3 to provide a multiple tunnel junction between the control electrode 11 and the memory node 10 gives rise to an extremely low leakage current from the node 10. However, the gate electrode 15 does not raise or lower the potential barrier structure effectively under the control electrode 11 and raises the electric field in the region between the gate region and the memory node 10.

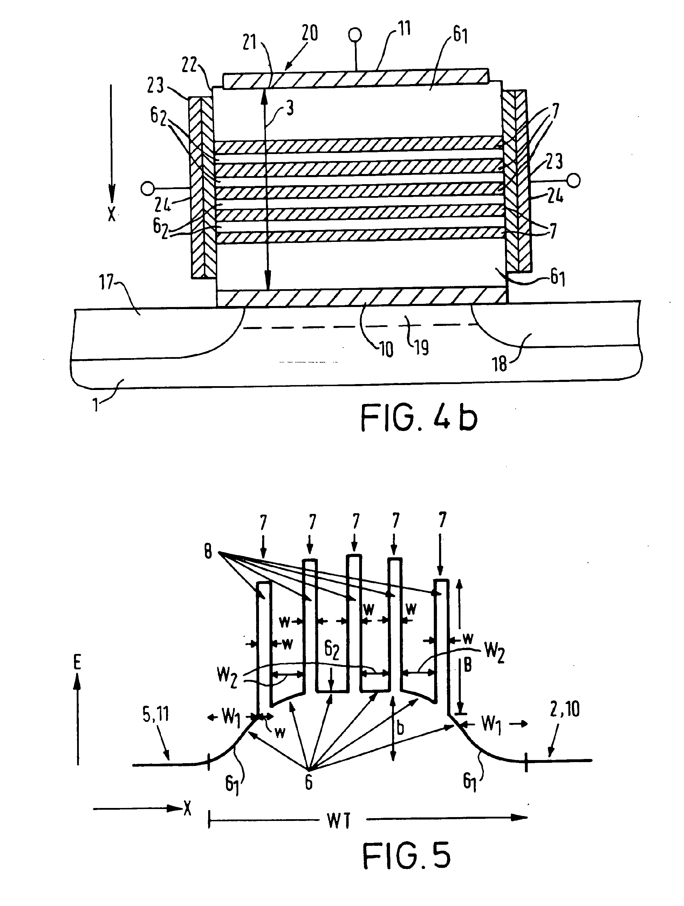

The present invention provides an improved gate configuration which can be used both for a transistor according to the principles of Figure 1 or for a memory device according to the principles of Figure 3, as will now be explained with reference to Figures 4a and 4b. Figure 4a illustrates the improved gate structure in relation to a transistor operative according to the principles described with reference to Figure 1, and Figure 4b illustrates the same gate structure applied to a memory device operative according to the principles of the memory of Figure 3.

The layer structure 3 shown in Figures 4a and 4b is arranged in the form of a pillar 20 upstanding from the substrate 1, with a top surface 21 and a peripheral side wall 22 which extends around the pillar. In accordance with the invention, a side gate 23 is formed along the side wall 22 so as to produce an electrostatic field into the pillar structure through the side wall to control the conductivity therein, by raising and lowering the barrier structure selectively. No significant controlling field is applied through the top surface 21 by the side gate 23.

In use, charge carriers flow vertically through the pillar structure from an electrode formed on the top surface 21. For a transistor in accordance with the invention, shown in Figure 4a, the top electrode comprises a source 5 operable in the manner previously described with reference to Figure 1 and the drain 2 is provided on the underside of the pillar. However, when the device is configured as a memory as shown in Figure 4b, the top electrode operates in the manner of the control electrode 11 described previously with reference to Figure 3 and the memory node 10 is disposed on the underside of the pillar structure. The charge stored on the memory node 10 controls the conductivity of the path 19 between source and drain regions 17, 18 formed in substrate 1, in the manner described with reference to Figure 3.

The side gate 23 is formed e.g. of conductive polysilicon material on an electrically insulating layer 24 , which may comprise silicon dioxide. The side gate 23 does not extend into the region occupied by the uppermost electrode 5, 11 and the gate voltage acts on the barrier structure so as to reduce the high electric field region.

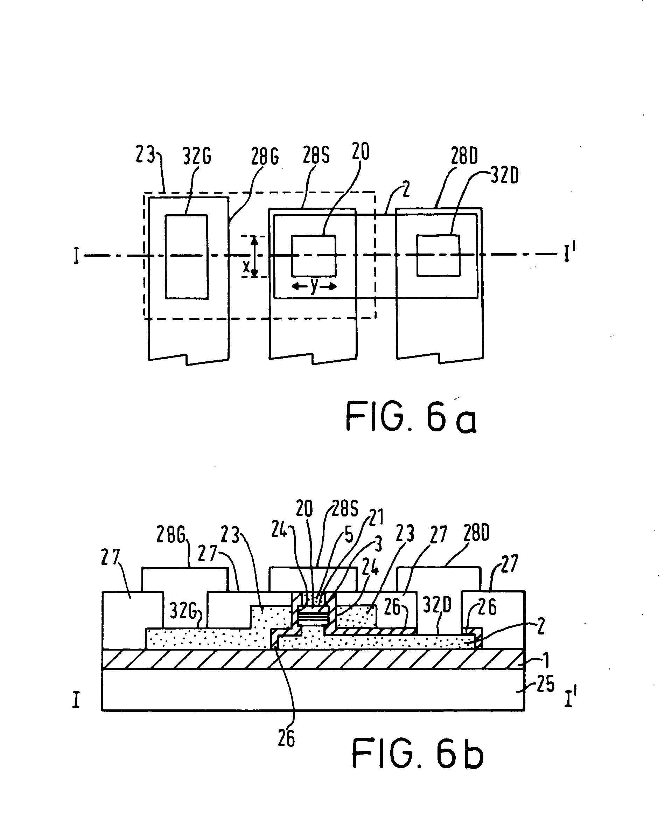

The layers 6, 7 are typically formed with the thicknesses and compositions previously described with reference to Figure 1, with the result that the energy band structure for the device is as shown in Figure 5, in the absence of a voltage applied to the top electrode 5, 11 or the side gate 23. The insulating layers 7 give rise to relatively high barriers 8 of height *B*, of a relatively narrow width dimension *w* corresponding to the width of the individual layers 7. In this example, the width dimension *w* is of the order of 3nm or less, typically of the order of 2nm.

The spacing of the individual barriers 8 is determined by the thicknesses of the layers 6 of the conductive silicon material. Towards the top and bottom of the layer structure 3, the layers 6 have a thickness *W*_{*1*} of the order of 50nm and in the central region of the stack, the layers 6 have a thickness *W*_{*2*} of 10nm or less, e.g. the order of 5nm.

Collectively, the layers of the structure 3 give rise to a barrier height *b* which is relatively low compared to the barrier height *B* of the individual layers, but which is relatively wide in terms of its physical dimension, corresponding to a width *W*_{*T*} of the entire multiple layer structure 3.

The effect of a voltage applied to the side gate 23 is to raise or lower the overall energy band diagram shown in Figure 5. The effect applying a voltage to the top electrode 5, 11 is to distort the band diagram in the manner shown in Figure 2b, so as to allow charge carriers to pass from the top electrode 5, 11 downwardly through the pillar structure, either to reach the drain 2 or charge the memory node 10 depending on the device concerned. In the absence of a voltage applied to the top electrode 5, 11, the barrier structure prevents charge leakage along the path between the top and the bottom of the pillar structure.

When used as a memory as shown in Figure 4b, the device operates as a fast static random access memory. The barrier height *b* typically gives rise to a small built-in potential of approximately 0.2V and the threshold voltage required on the gate electrode 23 under conditions of zero bias the control electrode 11 and the memory node 10, is -1.0V. The height of the overall barrier presented by the pillar structure is controlled by the bias applied to gate 23. A negative gate bias of about -4.0V applied to the gate electrode 23 causes stored charge to be retained on the memory node 10. The negative gate bias produces a potential barrier of approximately 3eV, which is high enough to keep stored electrons on the node for a period of approximately 10 years.

To write information, the voltage applied to gate 23 is kept to zero and a bias voltage of 1.0V is applied to the control electrode 11. Then, the overall barrier structure of the pillar forms a downwardly inclined slope in the manner shown in Figure 2b with the result that electrons can tunnel through the individual barriers 8 to reach the memory node 10. To read information, a voltage of -3.0V is applied to the gate electrode 23 and the source-drain current flowing in channel 19 is monitored in the manner previously described with reference to Figure 3.

When the device is used as a transistor as shown in Figure 4a, such that the top electrode 5 comprises a source and the underlying region 2 comprises a drain, the device will operate as a fast, normally-on transistor. A more practical example of such a transistor will now be described with reference to Figure 6.

As shown in Figure 6b, a silicon wafer 25 is provided with a thermally grown silicon dioxide layer 1, which acts as a substrate. The drain 2 comprises a layer of n⁺ polysilicon formed on the silicon oxide layer 1. The drain is encapsulated by an electrically insulating layer 26 of silicon dioxide.

The layer structure 3, which gives rise to the multiple tunnel junction configuration is formed so as to overlie the drain 2. The layer structure 3 is formed as a pillar 20 so as to be upstanding from the drain region 2 and is surrounded by the insulating silicon dioxide layer 24. The source 5 comprises a layer of n⁺ polysilicon, which overlies the top surface of the pillar 20.

The gate 23 comprises a layer of polysilicon which bounds the side wall 22 of the pillar 20, abutting the protective insulating layer 24, but does not cover its top surface 21.

The structure is covered by a protective, insulating layer 27 described in more detail hereinafter. As can be seen from Figure 6a, contact windows are formed in the oxide layer 27 and source, drain and gate electrodes 28S, 28D and 28G provide external connections.

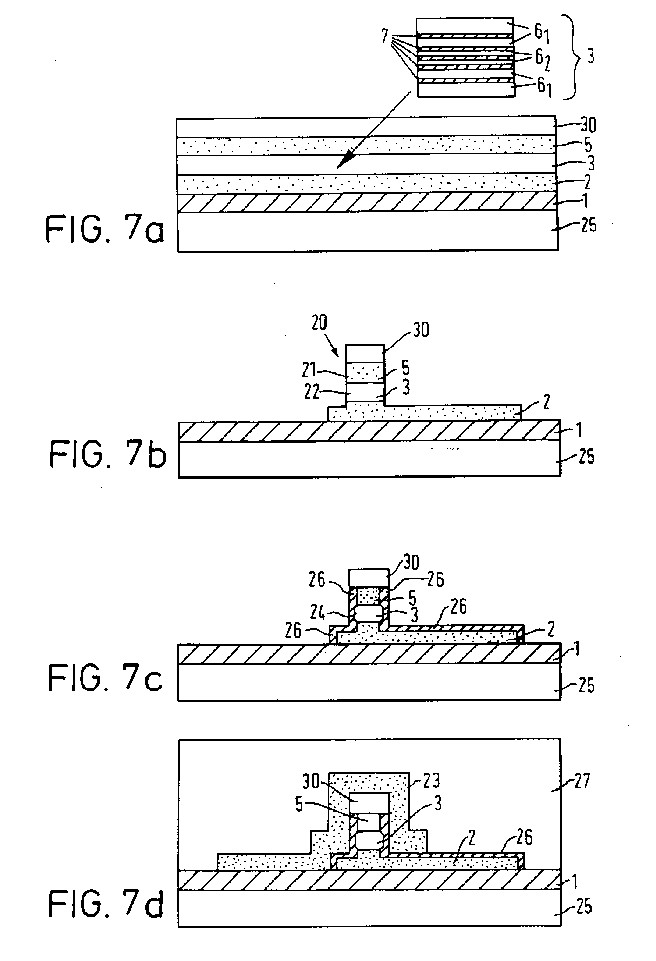

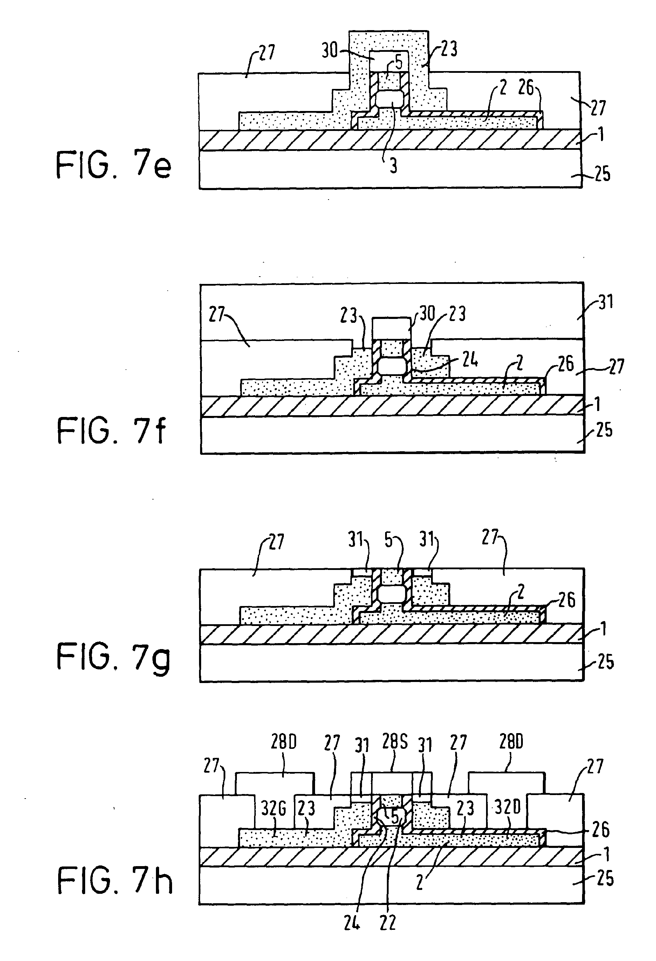

A method of fabricating the device shown in Figure 6 will now be described in detail with reference to Figure 7.

Referring to Figure 7a, the starting material comprises a silicon wafer 25 which is thermally oxidised at 1000°C to form a 600 nm layer 1 of SiO₂, which acts as an insulating substrate. Then, the layer 2, which is used to produce the drain, is formed on the SiO₂ layer 1. The layer 2 comprises 100 nm thickness polysilicon deposited in a reactor by low pressure chemical vapour deposition (LPCVD). A silicon dioxide layer of thickness of the order of 10nm is then deposited on the surface of the layer 2. Arsenic ions are then implanted into the layer 2 in order to form a n⁺-doped conductive layer that can be used as the drain. The arsenic ions are implanted with a dosage of 3 × 10¹⁵cm⁻² at an energy of the order of 25KeV through the oxide layer (not shown). The oxide layer is then removed by wet etching using a 20:1 BHF solution.

Thereafter, the multiple layer structure 3 is formed on the layer 2. The multiple layer structure 3 consists of a stack of silicon and silicon nitride layers 6, 7. Initially, the layers 6₁ of silicon are formed to have a relatively large thickness *W*_{*1*} = 50nm and then, for the major part of the stack, the thickness of the layers 6₂ is of the order of *W*_{*2*} *=* 5nm. At least one further layer 6₁ of thickness *W*_{*1*} is formed at the top of the stack. In this example, two such layers 6₁ are formed at the top. This can be seen in detail in the enlarged detail of the section shown in Figure 7a.

The layers 6, 7 are formed in the LPCVD reactor. The process involves thermal nitridation of silicon, as described in detail by M. Moslehi and K. C. Saraswat, IEEE Trans. Electron Device, ED. 32, p 106 (1985) so as to form thin, tunnel junctions, in which the barrier thickness of the nitride is self-limited to around 2-3nm depending on the growth temperature, with a tunnel barrier height of the order of 2eV.

The layer structure 3 is repeatedly built up by firstly depositing a silicon layer in the LPCVD reactor at 770°C in SiH₄ gas to achieve the appropriate thickness of silicon for the relevant layer as shown in Figure 7a. Thereafter, the surface of the deposited silicon is directly converted to silicon nitride at 930°C for 20 minutes in 100% NH₃ gaseous atmosphere at 1 Torr in the reactor. Then, a further layer of silicon is deposited on the silicon nitride in the same chamber and the process is repeated. Accordingly, pure silicon nitride without any silicon oxide is formed in the successively deposited layers 7.

Then, a layer 5 of polysilicon is deposited with a thickness of 100nm by LPCVD. A silicon dioxide layer of thickness of the order of 10nm is then deposited on the surface of the layer 5. Arsenic ions are implanted at an energy of 25 KeV at a dosage of 5 × 10¹⁵cm⁻² through the oxide layer (not shown) in order to change the silicon layer 5 to an heavily doped, n-typed layer. Thermal annealing at 800°C for one minute is then carried out in order to activate the arsenic ions and provide heavily n-doped electrical characteristics in the layer 5, which is later used to provide the source of the device. A silicon oxide layer 30 of thickness 100nm is then deposited on the layer 5.

Referring to Figure 7b, the silicon oxide layer 30 is then patterned using optical lithography and a dry etching method in an atmosphere of CHF₃ and argon gas, in a manner well known ***per se***. Then, the layers 5 and 3 are patterned using a conventional dry etched method in CF₄ gas, using the photo-resist and the patterned layer 30 as a mask.

Then, in a separate patterning step, using conventional optical lithography and dry etching in an atmosphere of CF₄ gas, the layer 2 is etched so as to achieve the pattern shown in Figure 7b. The layer structure 3 is thus etched into the form of a pillar 20 with a top surface 21 and a side wall 22, upstanding from the drain region 2.

Next, as shown in Figure 7c, silicon dioxide layers 24, 26 are grown by thermal oxidisation to overlie the etched portions of the n⁺ polysilicon layers 5, 2 and the pillar structure 3. The thickness of the oxide layer 24 around the pillar structure is of the order of 10nm whereas the layer 26 that covers the source and drain regions 5, 2 is of the order of 50nm thickness. The thickness of the silicon dioxide on the highly doped regions 5 and 2 is larger than the thickness of the silicon dioxide on the intrinsic silicon of the pillar 3 due to the SELOCS.

As shown in Figure 7d, a layer of polysilicon 23 is deposited to a thickness of 100nm by LPCVD. A thin silicon dioxide layer (not shown) of thickness of the order of 10nm is then deposited on the surface of the layer 23. Arsenic ions are then implanted at an energy of 25KeV and a dosage of 5 × 10¹⁵cm⁻² through the oxide layer in order to change the polysilicon layer 23 to a heavily doped n-type layer.

Thermal annealing at 800°C for one minute is then carried out in order to activate the arsenic ions and provide heavily n-doped electrical characteristics in the layer 23, which is later used to provide the gate of the device. The layer 23 is then patterned using optical lithography and a dry etching method in an atmosphere of CF₄ gas. Then, the protective layer 27 is formed, which comprises BPSG (boron and phosphorous contained silicade glass) to a thickness of 500nm, and HSG (spin on glass) to a thickness of 250nm.

As shown in Figure 7e, the BPSG and HSG layer 27 is then etched back by a dry etching method in an atmosphere of CH₂F₂ and argon gas so as to expose the top of the polysilicon layer 23.

As shown in Figure 7f, the top of the polysilicon layer 23 is etched to a level between the top and bottom surfaces of the n⁺ polysilicon layer 5, by a dry etching method in an atmosphere of WF₆ gas. Then, a silicon dioxide layer 31 is deposited to a thickness of 1000nm.

As shown in Figure 7g, the silicon dioxide layer 31 is polished by a CMP (chemical mechanical polish) method so as to expose the top of the polysilicon layer 5, so as to provide access to the eventual source.

Then, as shown in Figure 7h, a contact window 32D is etched through the oxide layers 26, 27 in order to allow an external electrical connection to be made to the drain layer 3. At the same time, a contact window 32G is opened to the gate 23. The contact windows can be seen clearly in the plan view of the device shown in Figure 6a.

Next, a metallisation layer 28 is formed by sputtering in order to provide electrical connection to the source, drain and gate, in regions 28S, 28D and 28G. The layer 28 comprises an initial layer of titanium of 100nm thickness overlaid by a layer of aluminium/silicon (1%) to a thickness of 1000nm, produced by conventional sputtering techniques.

As shown in Figure 7h, electrical insulation spaces are etched into the 37 metallisation layer 28 so as to provide the individual portions 28D, 28S and 28G.

The portion 28S thus provides a connection to the source region 5. The portion 28G provides a connection through window 32G to the layer 23 which surrounds the pillar structure 20 that gives rise to the multiple channel junction device. The layer 23, is insulated from the pillar structure 20 by the thin oxide layer 24 and thus acts as a side gate that extends along the side wall 22 of the pillar structure 20.

During and after the growth of the layers 6, 7 of the multi-layer structure 3, the overall wafer is heated to 900-1000°C for several hours. However, to ensure that the resulting device operates successfully, the dopants from the heavily doped source and drain regions 5, 2 should not be permitted to migrate into the silicon layers 6₂ of the layer structure 3. In the described embodiment, the uppermost and lowermost layers 7 of silicon nitride in the layer structure 3 act as barriers to the n⁺ dopants in the layers 2, 5 and prevent them from diffusing into the central region of the multi-layer structure 3 during the heating process.

Figure 6a shows the active region of the transistor to be X x Y. Typically X = Y = 150nm. A pillar dimension X = Y< 20nm can be achieved by means of a self-limiting oxidation process described by H. I. Lie, D. K. Biegelsen, F. A. Ponce, N. M. Johnson and R. F. W. Pease, Appl. Phys. Lett. vol. 64, p 1383, 1994 and H. Fukuda, J. L. Hoyt, M. A. McCord and R. F. W. Pease, Appl. Phys. Lett. vol 70, p 333, 1997. In this process, a retardation in the oxidation rate occurs as a result of a large compressive stress in the oxide skin near the silicon core/oxide interface, which can reach 10Gpa, which is responsible for the self-limiting effect.

It will be understood that the transistor structure takes up a small space on the substrate and the arrangement of the side gate 23 minimises the high electric field region and conflict for space on the substrate that occurs in the embodiments described in our EP-A-0892440 ***supra***.

It will be understood that the principles of construction described with reference to Figure 7 can also be used to provide a side gated configuration for a memory cell; thus, the drain region 2 shown in Figure 6 can be replaced by a polysilicon layer of e.g. 30nm thickness to provide the aforementioned memory node 10. Conventional source and drain regions can be formed in the wafer 25 in a manner well known ***per se***, thus to provide source and drain regions corresponding to the regions 17 and 18 shown in Figure 3 and 4b, with a conductive source-drain path between them.

A number of modifications to the pillar structure 20 will now be described, which give rise to different operating characteristics for the transistor or memory fabricated in accordance with the invention.

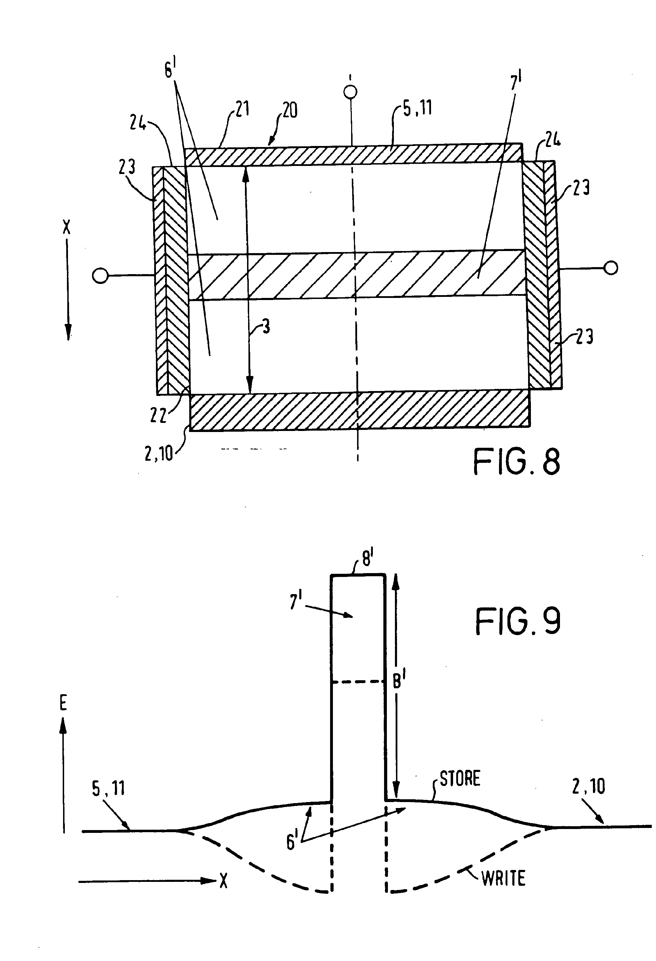

Referring now to Figure 8, this illustrates an example of a pillar structure which can be used to provide a normally off transistor and a non-volatile memory. The configuration can be considered as a modification of the arrangement shown in Figure 4a or 4b and the same reference nomenclature has been used in Figure 8. The pillar structure is thus provided with the side gate 23 and insulating region 24.

The pillar structure 20 consists of a relatively thick insulating layer 7' typically of silicon dioxide or silicon nitride. The insulating layer is of a thickness of the order of 3-30nm for silicon dioxide and from 4-30nm for silicon nitride formed by plasma nitridation at 550°C in NH3 atmosphere with RF power of 300-500W. The insulating layer is sandwiched between intrinsic silicon layers 6' of a thickness of 50nm. The energy band profile associated with the pillar structure is shown in Figure 9. The energy band profile includes a relatively wide barrier 8' of height *B'* with a width dimension corresponding to the thickness of the layer 7'.

In use, the device when configured as a memory, operates as a fast non-volatile random access memory (RAM) because the energy barrier 8' created by the insulating layer 7' keeps electrons stored in the memory node 10 without the need to apply an external gate voltage to the gate 23. The height *B*' of the energy barrier is of the order of 2.0eV for silicon nitride and 3.0eV for silicon dioxide.

When a bias voltage is applied to the gate 23, the energy barrier *B*' is lowered as shown in dotted outline in Figure 9. This effect is used to lower the barrier to permit charge to be written onto the memory node 10. Additionally, a voltage is applied to the control electrode 11 to produce a potential gradient in the manner of Figure 2b (not shown in Figure 9), so that charge carriers move towards the node 10. In the case of a silicon nitride barrier 7', the voltage applied to the side gate 23 is of the order of 3V and the voltage applied to the control electrode is of the order of 1V. In this configuration, charge carriers pass the insulating layer 7' to reach the memory node 10, along a path from the control electrode 11. Thereafter, when the voltages are removed from the electrodes 11, 23, charge retained on the gate voltage by the barrier *B*' and the retention time can be of the order of 10 years. Accordingly, the device operates as a fast non-volatile RAM. When the pillar structure of Figure 8 is used in a transistor configuration, with the source 5 and drain 2, it will operate as a normally-off transistor.

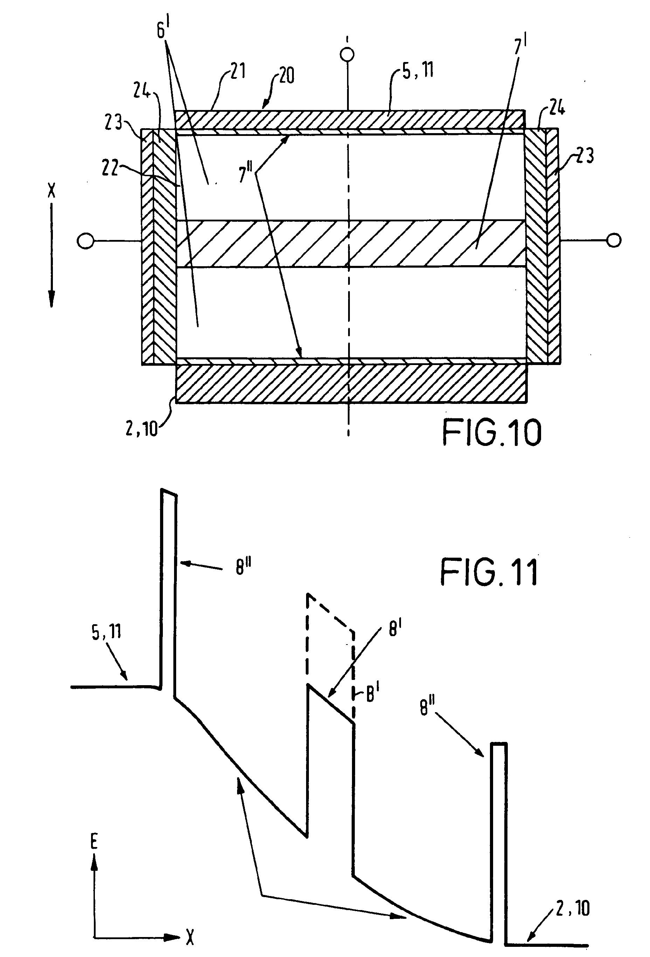

A modification is shown in Figure 10, which includes additional, relatively thin insulating layers 7" adjacent the uppermost electrode 5, 11 and the lowermost region 2, 10, which give rise to additional barriers 8" in the corresponding energy band diagram shown in Figure 11. When used as a memory, the layers 7" avoid massive electron re-distribution around the insulating layer 7, the control electrode 11 and the memory node 10 and so achieve an improved downward potential slope when the voltages are applied to the gate 23 and the control electrode 11 so as to write or erase charge from the node 10. The energy band diagram of Figure 11 illustrates the situation in which a write voltage is applied to the control electrode 11 and also to the gate 23, with the values previously described in relation to Figure 8. The effect of the voltage applied to the control electrode 11 is to configure the band diagram into a downward slope from the control electrode 11 to the memory node 10 so as to allow electrons to move down the slope onto the memory node, with the electrons tunnelling through the barriers *B*. The effect of the gate voltage 23 is to lower the height of the barriers *B.* The effect on the barrier *B'* is shown in Figure 11. The barrier is reduced from the level shown in dotted outline as a result of the voltage applied to gate 23. When the pillar structure 20 is formed of silicon nitride and polysilicon layers 6, 7 as previously described, the additional thin layers 7" are typically of a thickness of 1-2nm with the polysilicon layers 6' being of a thickness of the order of 5-30nm.

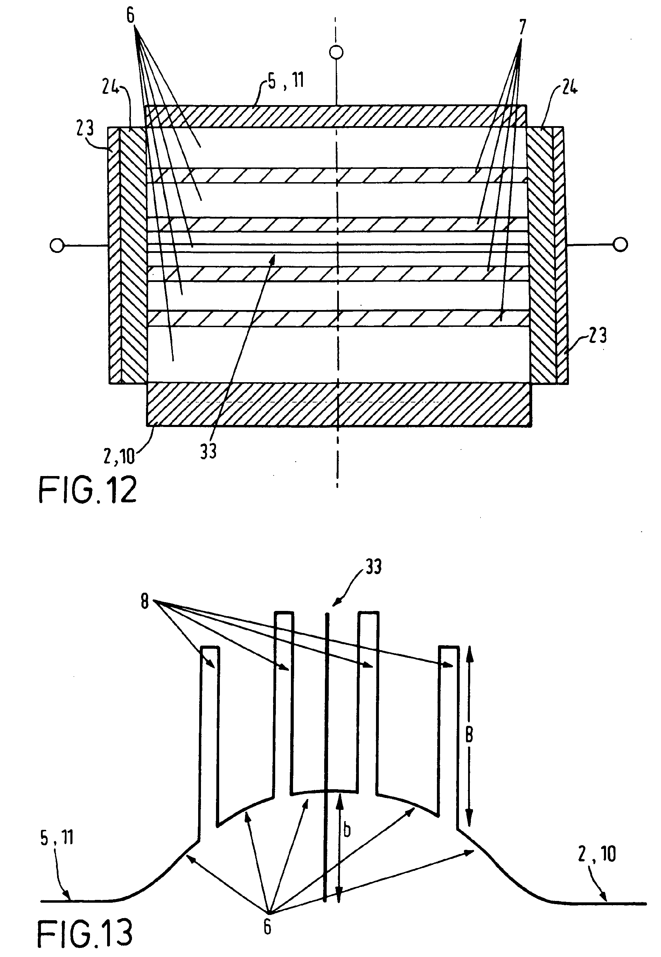

Another modification is shown in Figure 12 to provide a static random access memory (SRAM) or a dynamic random access memory (DRAM) which obviates the need for conventional refresh circuits. The general side gated pillar structure is the same as that shown in Figure 4 but with the addition of a thin p-type silicon layer 33. It will be appreciated that this layer which is typically of the a thickness of 1-2nm, can be formed in the LPCVD reactor in a conventional manner, during the build up of the layers 6, 7. The dopant used for the layer 33 is typically boron with a dopant concentration of the order of 10¹⁸cm⁻³. This creates a built-in potential barrier of the order of 1.2V with a result that charge can be stored at the memory node 10 for a time of the order of a few minutes without an applied bias to the gate electrode 23. Therefore, the memory device does not require conventional heavy duty refresh circuits usually needed in a fast DRAM. If it is required to retain information for longer periods of time, a negative bias voltage is applied to the gate electrode 23. A bias voltage of -1.0V or -0.5V give rise to retention times of 10 years and 1 hour respectively. To read and write information, gate bias voltages of 0.0V and 1.0V are applied respectively to the gate electrode 23. It will be understood from the foregoing that in order to read information from the node, a source-drain voltage is applied to the source and drain 17, 19 (not shown in Figure 12) and the resulting source-drain current is detected. The level of current will depend on the level of charge stored on the memory node 10.

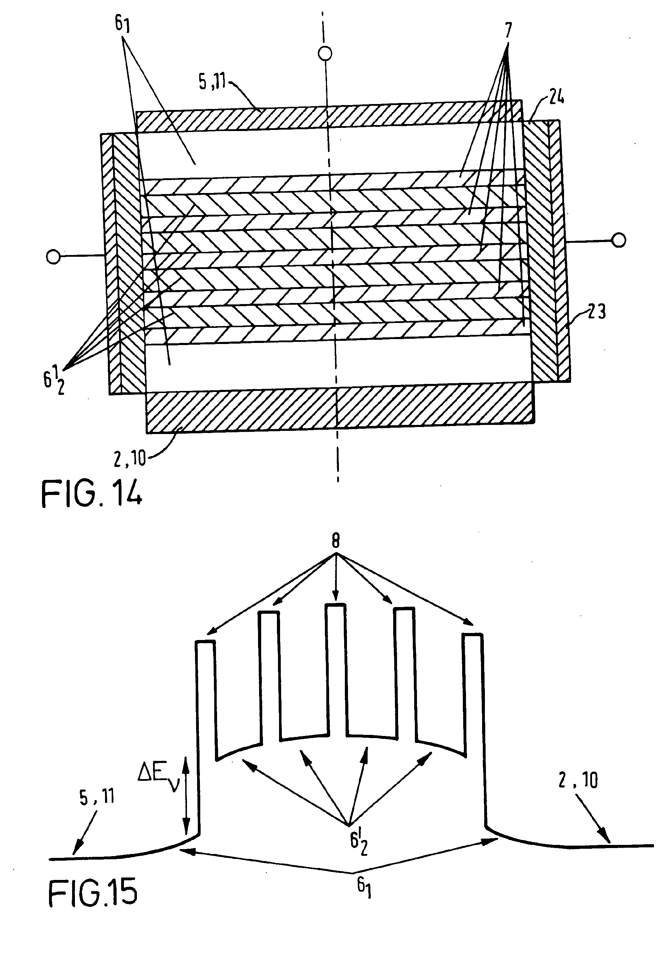

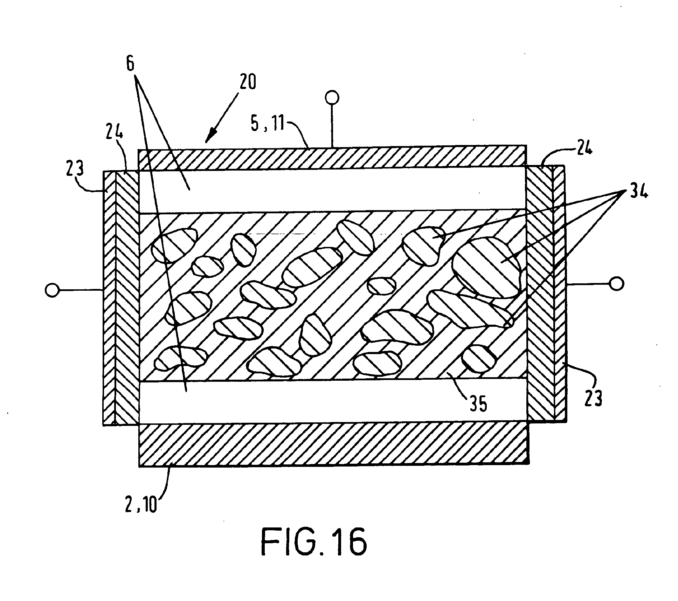

Another configuration is shown in Figure 14 in which some of the regions 6 are formed of a material with a larger energy band gap in order to introduce a band gap discontinuity. In the embodiment shown in Figure 14, the thinner layers 6₂' are formed of a wide gap material such as a metal-semiconductor compound e.g. SiC, whereas the regions 6₁ are formed of polysilicon in the manner previously described. It will be understood that the appropriate dopant can be introduced during the LPCVD process used to manufacture the pillar, when the layers 6₂' are formed. The resulting band energy profile is shown in Figure 15 and it will be seen that the band edge is lifted in the regions of the layers 6₂', giving rise to a band edge discontinuity Ä Eᵥ. In this example, the band edge discontinuity is formed in the valence band but it will be understood that the discontinuity could be formed in the conduction band if appropriate materials is used electrons are used as the carriers. In this example, the valence band discontinuity is of the order of 0.5eV. This is effective for retaining information for a time of the order of 1 hour without the application of a bias to the gate electrode 23. Therefore, the memory device does not require fast refresh circuits in the manner of a convention DRAM. In order to retain information for longer periods of time, a positive bias of 0.5V can be applied to the gate electrode 23, which achieves a retention time of the order of 10 years. To read and write information, gate bias voltages of -0.5V and -1.5V are applied to the gate electrode 23. The reading and writing is then carried out in the manner previously described.

When used as a transistor, the pillar structure of Figure 14 gives rise to a normally-off transistor.

Referring to Figure 16, another example of the side-gated pillar structure 3 is shown in which the barrier configuration is provided by a cluster of granular semiconductor or conductor islands 34 are formed in an insulating matrix 35. In this example, the matrix 35 is sandwiched between layers of polysilicon material 6 of 50nm thickness. The islands 34 may comprise silicon, germanium, amorphous silicon or metallic dots such as gold or aluminium. A number of different methods of preparing nanometre scale islands will now be described.

### 1. Method of Segregating Nanometre Scale Ge Crystallites from Si-Ge-O Mixture Films

Si-Ge-O mixture films were prepared by radio frequency magnetron sputtering (RFMS) or ion beam sputtering (IBS). The sputtering target consisted of a 99.99% pure SiO₂ glass plate of 100mm in diameter on which were disposed a number of high purity Ge chips 5mm square. Sputtered material from the target was deposited on a Si substrate of a thickness of 200nm. The number of Ge chips distributed on the circular SiO₂ glass plate was selected in order to control the amount of Ge sputtered onto the target.

In the case of RFMS, the sputtering was carried out at 1.25kW at 13.56 MHz rf power in an argon gas atmosphere at a pressure of 3m Torr. In the case of IBS, sputtering was carried out with a dc power source at 1kW in an argon atmosphere at 0.3m Torr.

In more detail, the process was performed in a deposition chamber which was first evacuated by means of a cryo-pump to a pressure of 3 x 10⁻⁷ Torr. Next, argon gas was introduced and the electrical power previously described, was applied for sputtering. After 7 minutes, a SiO₂ glass was formed on the target supersaturated with Ge. The sample was then annealed at 300-800°C in argon gas for 30 minutes - 4 hours. As a result, Ge nanometre scale crystallites segregated in the glass. The number of Ge chips, the annealing temperature and the annealing time were chosen so as to control the density and size of the nano-crystallites of Ge formed in the class. Table 1 below gives examples.

**Table 1**

| Sample No. | Annealing Temp. | | Annealing time | Average Diameter |
|---|---|---|---|---|
| | | | | |
| | 1 | 300°C | 30 min | |
| | 4.2nm | | | |
| | 2 | 600°C | 30 min | |
| | 6.0nm | | | |
| | 3 | 800°C | 30 min | |
| | 6.5nm | | | |

### 2. Preparation of Hydrogenated Amorphous Silicon by Plasma Enhanced Chemical Vapour Deposition Method

In this method, capacitively coupled rf-plasma enhanced chemical vapour deposition was used in the preparation of very thin, hydrogenated amorphous silicon. A deposition chamber was first evacuated down to a pressure of 10⁻⁷ Torr before the introduction of reaction gases. A silicon substrate mounted on a grounded electrode in the chamber was heated up to a temperature of 250°C. A gas mixture of SiH₄ and H₂ was introduced into the deposition chamber through a mass flow controller. The gas flow rates were 10 and 40 sccm respectively. A gas pressure of 0.2 Torr was maintained by an automatic pressure controller. Substitutional doping was attained by introducing PH₃ or P₂H₆ gas during the deposition in order to provide n-type and p-type hydrogenated amorphous silicon respectively. In this example, 5 sccm or 0.2% PH₃ diluted in H₂ was added as an n-type dopant. 13.56 MHz RF power at a level of 10W was applied onto electrodes in the chamber via an automatic matching box so as to maximise the forward power and minimise reflections, thereby establishing a plasma in the chamber. The deposition rate in this case was 0.08 nm/sec. Deposition was carried out for 50 seconds to obtain a layer thickness of 4 nm containing hydrogenated amorphous silicon.

### 3. Preparation of Microcrystalline Silicon by Plasma Enhanced Chemical Vapour Deposition Method

Capacitively coupled rf-plasma enhanced chemical vapour deposition was used to prepare microcrystalline silicon. The main reaction chamber was isolated and connected to a load lock chamber by a shutter which can be opened easily. Loading and unloading of the samples into and from the main chamber is carried out through the load lock chamber. The pressure in the chamber was determined by an automatic pressure controller. The deposition chamber was evacuated by a turbo-molecular pump down to a pressure of 10⁻⁷ Torr before introduction of the reaction gases. The substrates to receive the deposited layer were situated on a grounded electrode of 15 cm diameter heated to a temperature of 250°C. The distance between the electrodes was fixed at 3 cm. The gas mixture of SiH₄ and H₂ was introduced into the deposition chamber through a mass flow controller. The gas flow rates for SiH₄ and H₂ were selected to be 1 and 100 sccm respectively. During this process, the gas pressure was maintained at 0.15 Torr by means of an automatic pressure controller. Substitutional doping is obtained by introducing phosphine or diborane gases during the deposition process, in the same plasma to provide n-type and p-type amorphous silicon respectively. In this example, 2 sccm of 0.2% phosphine diluted in hydrogen was added as an n-type dopant. 80 power was applied at 13.56 MHz to the electrodes in the chamber by means of an AMC, so as to maximise the forward power and minimise the reflected power. The deposition rate was 0.05nm/sec. The deposition process was contained for 80 seconds to achieve a 4nm layer of microcrystalline silicon.

### 4. Preparation of Stacking Structures of Silicon Nitride and Amorphous or Microcrystalline Silicon by Plasma Enhanced Chemical Vapour Deposition

To achieve a stack structure of layers of silicon nitride or microcrystalline silicon can be achieved using either method No. 2 or 3 discussed above to produce the amorphous or microcrystalline silicon and interspersed silicon nitride layers can be also prepared in a similar way by using a gas mixture of SiH₄, NH₃ and H₂.

To prevent contamination between the silicon and silicon nitride layers, the individual films are prepared in different deposition chambers which are connected by means of a vacuum transfer mechanism.

### 5. Preparation of Silicon Films by Other Methods

The following are examples of other methods which can be used to prepare the amorphous and microcrystalline silicon films: thermal chemical decomposition, photo-chemical vapour decomposition, spattering, ion beam deposition, cluster ion beam deposition and molecular beam deposition. These methods can be combined with thermal annealing, rapid thermal annealing and laser annealing to achieve a wide range of microcrystalline silicon configurations.

In a specific example, silicon grains are formed with insulating grain boundaries, the grains have a dimensional range of 3-10nm and preferably 5 nm or less. In the resulting structure illustrated schematically in Figure 16, a current threshold of about 0.5V is formed. As a result, information can be stored on the memory node 10 for a time of the order of a few minutes, without a bias applied to the gate electrode 23. Information can be retained for longer periods of time by applying a bias voltage of -1.0V or -0.5V to the gate electrode 23 to achieve retention times of 10 years and one hour respectively. To read/write stored information, gate bias voltages of 0V and 1V are applied respectively to the gate electrode 23.

When used as a transistor, the pillar structure 20 of Figure 16 gives rise to a normally-off transistor device.

It will be understood that the grain size of intrinsic polysilicon layer 6 in previously described structures can be formed as small as 3-10nm. During thermal nitridation, grain boundaries are also converted to silicon nitride so that grains are also surrounded by insulation of 2-3nm thickness. It will be also understood that the composite layer of conductive and insulator structure Figure 16 can be used with any of the pillar structure previously described. The small grain size enhance the energy barrier effects due to the charging energy and quantum size effects, as well as the enhancement of electron localisation since resistance of each tunnel junction can be increased as the junction area is reduced. Also the leakage current due to the electron-hole pair creation can be reduced because the generated electron-hole pair would recombine inside the grain region, because the separation outside the grain is not energetically preferable due to the increase of the charging energy.

The device shown in Figure 16 has node 10 and layer 6. However, it is possible to omit node 10 and layer 6 and the islands 34 can be used as the node.

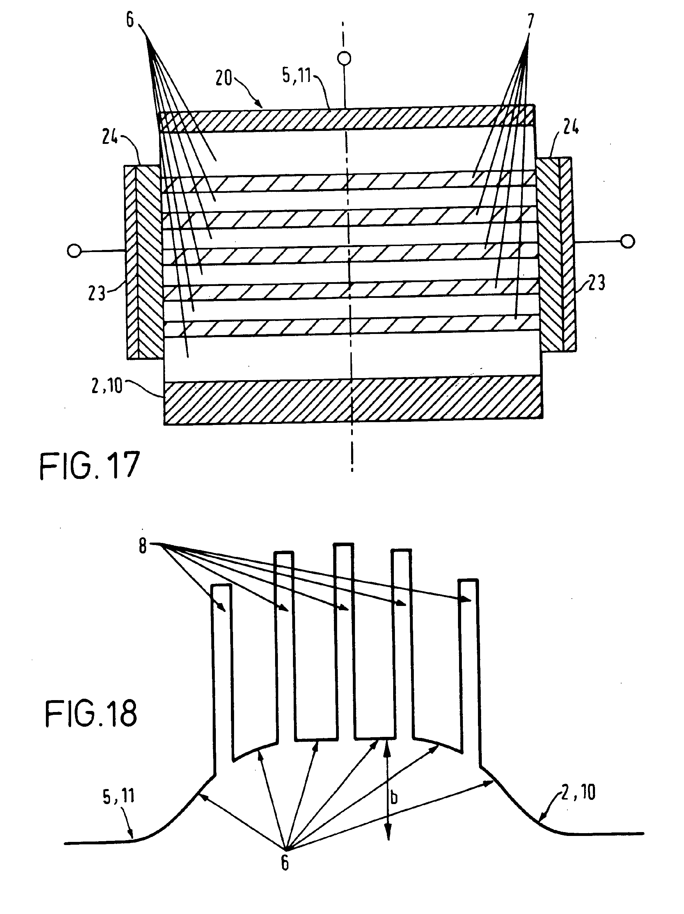

Referring now to Figure 17, this shows a modification to the side gate structure, which can be considered as a modification of the configuration shown in Figure 4. In this device, the insulating oxide layer 22 of Figure 4 is replaced by a semiconductor layer 36 so as to form a junction gate. In the example shown in Figure 18, the region 36 comprises p-type silicon. The pillar structure 20 includes layers 6, 7 of conductive polysilicon and insulating silicon nitride as described previously with reference to Figure 4. The side gate 23 is formed of polysilicon as described previously.

The effect of the p-type region 36 is to create a built-in potential *b* of 1.0V in the energy band profile, as shown in Figure 18. As a result, the current threshold voltage in this device is of the order of -0.1V. Therefore, when uses as a memory device, a low voltage operation can be achieved as the refresh operation can be less frequent than for a conventional DRAM. Negative bias voltages of - 1.6V and -1.1V applied to the gate electrode 23 produce retention times at the node 10 of the order of 10 years and one hour respectively. To read/write information from the node 10, gate bias voltages of -0.8V and 0.4V are applied to the gate electrode 23.

When used as a transistor, the pillar structure 20 of Figure 17 gives rise to a normally-on transistor device.

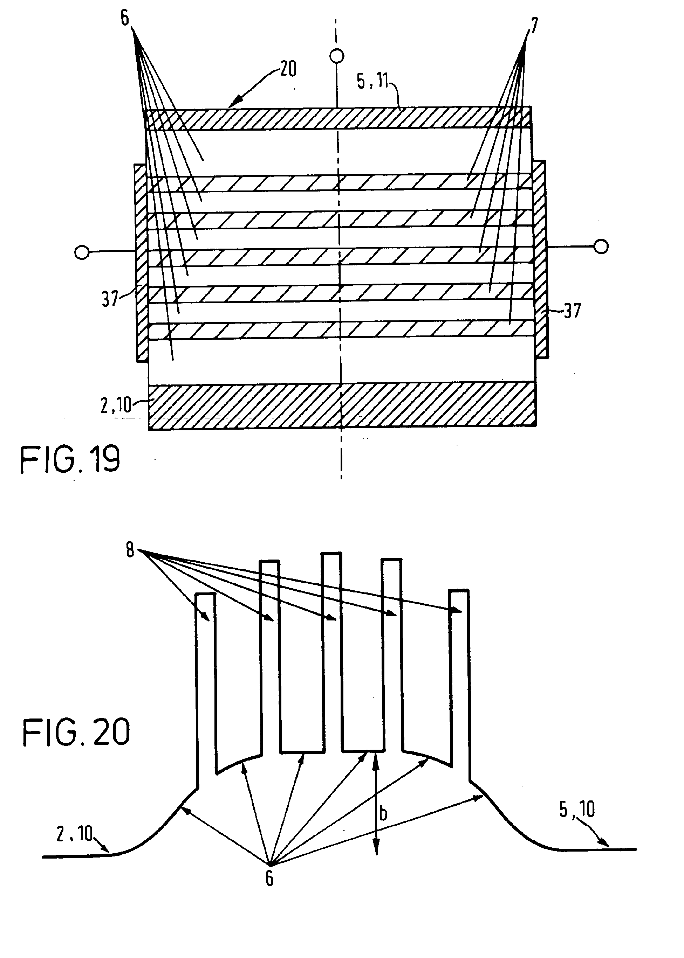

A pillar structure 20 with an associated Schottky side gate structure is shown in Figure 19, which can be considered as a modification of the configuration of Figure 4. In the embodiment of Figure 19, the insulating later 22 is omitted and a metallic side gate 37 is applied directly to the pillar structure 3 on its side wall 22 in order to form a Schottky gate.

The side Schottky gate 37 creates a built-in potential *b* of up to 0.4V in the pillar structure 20. The resulting current threshold voltage is of the order of -0.3V. Thus, when used as a memory device, low voltage operation can be achieved and the refresh operation can be less frequent that for a conventional DRAM. Negative bias voltages of -1.8V and -1.3V when applied to the gate electrode 37 can achieve retention times of 10 years and one hour respectively. To read/write information form the memory node 10, gate bias voltages of -1.0 and 0.2V are applied to the gate electrode 37. In a typical example, the Shottky metal gate 37 is formed of WSi or aluminium. It will be appreciated that the process steps described with reference to Figure 7 will be modified appropriately to produce the Shottky gate of a suitable material.

The pillar structure of Figure 20 can also be used in a transistor structure; a normally on transistor is thereby provided.

It will be understood that the junction gate of Figure 17 and the Schottky gate of Figure 19 can be used with any of the pillar structures previously described and not only the pillar structure of Figure 4.

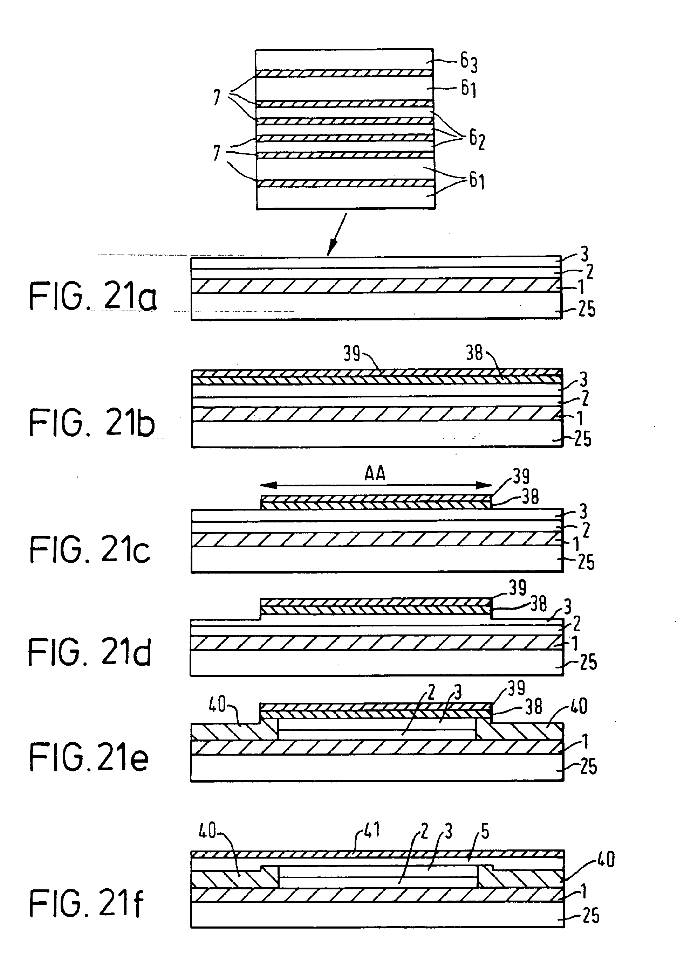

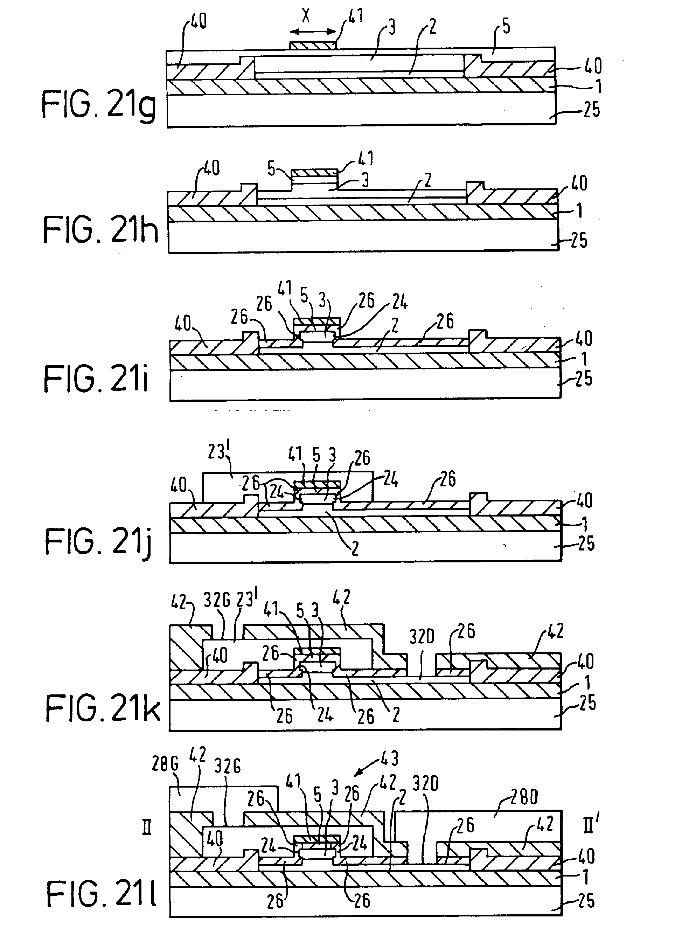

Another method of fabricating a transistor device in accordance with the invention will now be described with reference to Figure 21. The starting materials are the same as those used in the method described with reference to Figure 7. Thus, referring to Figure 21a, silicon wafer 25 is thermally oxidised as 1000°C to form a 600 nm thickness layer 1 of silicon dioxide which acts as an insulating substrate. Then, a layer 2, which is used to produce the drain, is formed on the silicon dioxide layer 1. The layer 2 comprises 100nm thickness polysilicon deposited by LPCVD in a reactor. A thin silicon dioxide layer (not shown) of thickness of the order of 10nm is deposited on the surface of the layer 2. Arsenic ions are then implanted into the layer 2 so as to form a n⁺-doped conductive layer that can be used as the drain. The arsenic ions are implanted with a dosage of 3 × 10¹⁵cm⁻² at an energy of the order of 25 KeV, through the oxide layer. The oxide layer is then removed by wet etching using a 20:1 BHF solution. Thereafter, a stack of the silicon and silicon nitride layers 6, 7 are grown so as to form the multiple layer structure 3 that gives rise to the multiple tunnel junction. Initially, the layers 6₁ of silicon are formed to have a relatively thickness *W*_{*1*} = 50nm and then, for the major part of the stack, the thickness of the layers 6₂ is of the order of *W*_{*2*} = 5nm. At least one further layer 6₁ of thickness *W*_{*1*} is formed at the top of the stack and in this example, a further layer 6₃ of silicon is formed with a thickness of 30nm. The layers 6, 7 are formed in the LPCVD reactor. The process involves thermal nitridation of silicon as described by Moslehi & Saraswat, ***supra***.

As previously described with reference to Figure 7, the layer structure is built up successively by firstly depositing a silicon layer in the LPCVD reactor at 770°C in SiH₄ gas to achieve the appropriate thickness of silicon for the relevant layers shown in the insert in Figure 21a. Thereafter, the surface of the deposited silicon is directly converted into silicon nitride at 930°C for 20 minutes in 100% NH₃ gaseous atmosphere at 1 Torr in the reactor. Then, a further layer of silicon is deposited on the silicon nitride in the same chamber. Accordingly, pure silicon nitride without any silicon dioxide is formed between the successive deposited silicon layers.

Referring to Figure 21b, a 10nm thick layer 38 of silicon dioxide is formed by thermal oxidisation over the layer structure 3 and a silicon nitride layer 39 of thickness 160nm is deposited at a temperature of 740°C.

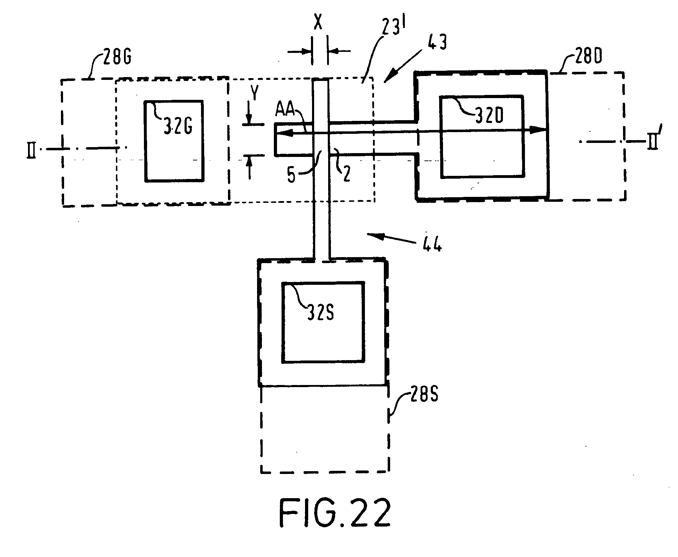

Referring to Figure 21c, the layers 38, 39 are then patterned using optical lithography and a dry etching method in an atmosphere of CHF₃ and argon gas, in a manner well known ***per se***. The resulting structure has a lateral width dimension AA and a breadth, shown in Figure 22, of a dimension Y.

As shown in Figure 21d, the patterned layers 38, 39 are then used as a mask in order to dry etch the multiple layer structure 3 so as to remove most of the layers 6, 7 outside of the dimension AA, but leaving a thickness of approximately 30nm of the structure 3 outside of the masked pattern. This remaining portion of the region 3 is then converted into silicon dioxide by thermal oxidisation to form regions 40 in order to isolate adjacent transistors (not shown) formed by the inventive method on the same substrate 1. The electrically insulating regions 40 are shown in Figure 21e.

Referring to Figure 21f, the silicon nitride and silicon dioxide layers 38, 39 are then removed using orthophosphoric acid at 160°C and a 20:1 BHF solution. Then, a layer 5 of polysilicon is deposited with a thickness of 100nm by LPCVD. A thin silicon dioxide layer (not shown) of thickness of the order of 10nm is deposited on the surface of the layer 5. Arsenic ions are implanted at an energy of 25KeV and a dosage of 5 × 10¹⁵cm⁻² through the oxide layer in order to change the silicon layer 5 into a heavily doped n-type layer for use as the source of the transistor. Thermal annealing at 800°C for one minute is then carried out in order to activate the arsenic ions and provide heavily doped electrical characteristics in the layer 5. A silicon dioxide layer 41 of thickness 100nm is then deposited on the layer 5.

Referring to Figure 21g, the silicon dioxide layer 41 is patterned using electron beam lithography and dry etching in order to provide an elongate region of width X which will be used to define a mask to define the extent of the source of the transistor.

Then, a shown in Figure 21h, the polysilicon layer 5 and the multiple layer structure 3 are etched in CF₄ gas, leaving a thickness of approximately 30nm of the layer structure 3, except under the portion of the etched layer 41, where the full thickness of the layers 3 and 5 remain.

As shown in Figure 21i, the silicon dioxide layer regions 24, 26 of thickness approximately 10nm and 50nm respectively are grown by thermal oxidation to overlie the etched portions of the multiple layer structure 3 and the exposed portions of the n-type source and drain regions 5, 2. The thickness of the silicon dioxide 26 on the highly doped regions 5, 2 is greater than that of the thickness of the oxide 24 on the intrinsic silicon of the layer structure 3, due to the SELOCS process.

As shown in Figure 21j, a layer 23' of polysilicon is deposited to a thickness of 100nm by LPCVD. A thin silicon dioxide layer (not shown) of thickness of the order of 10nm is deposited on the surface of the layer 23'. Arsenic ions are implanted at an energy of 25KeV and a dosage of 5 × 10¹⁵cm⁻² through the oxide layer in order to change the polysilicon layer 23' to a heavily doped n-type layer. Thermal annealing at 800°C for one minute is then carried out in order to activate the arsenic ions and provide heavily doped n-type electrical characteristics in the layer 23' which is later used to provide the gate of the device. The layer 23' is then patterned using optical lithography and a dry etching method in an atmosphere of CF₄ gas. Then as shown in Figure 21k, a silicon dioxide layer 42 of thickness 100nm is deposited on the device and a contact window 32D is etched through the oxide layers 42, 26 in order to allow electrical connection to be made to the drain layer 2. The contact window 32D is produced by optical lithography and wet etching using a 20:1 BHF solution. As part of the same process, a contact window 32G is formed for the gate 23'.

As shown in Figure 21l, a metallisation layer 28 is formed by sputtering in order to provide electrical connection to the gate and drain. The layer 28 comprises an initial layer of titanium of 100nm thickness, overlaid by a 1000nm of aluminium/silicon (1%) produced by conventional sputtering techniques. As shown in Figure 211, an electrical insulation space 43 is etched into the layer 28 so as to provide first and second contact portions 28D and 28G, which provide connections through the contact windows 32D and 32G to the gate and drain regions respectively.

The resulting device is shown schematically in plan view in Figure 22. From Figure 22, it can be seen that the process step described with reference to Figure 21k that formed the contact window 32D, 32G can also be used to form a contact window 32S through the silicon dioxide overlayer 41, so as to provide an external electrical connection to the heavily doped n-type region 5 that forms the source. Additionally, when the insulating gap 43 is formed, an insulating gap 44 shown in Figure 4 is also formed so as to define portion 28S of the sputtered metallic contact layer 28. This provides electrical connection through the contact window 32S to the source 5.

During and after the growth of the layers 6, 7 of the multilayer structure 3, the overall wafer is heated to 900-1000°C for several hours. However, to ensure that the resulting device operates successfully, the dopants from the heavily doped source and drain regions 5, 2 should not be permitted to migrate into the silicon layers 6₂ of the layer structure 3. In the described embodiment, the uppermost and lowermost layers 7 of silicon nitride act as barrier for the n⁺ dopants in the layers 2, 5 and prevent them from diffusing into the central region of the multi-layer structure 3 during the heating process. Figure 4 shows the active region of the transistor to be X x Y. Typically X = 50nm and Y = 200nm.

Referring again to Figure 211, it will be seen that the etched multi-layer structure 3 is formed into a pillar 20 upstanding from the drain region 2. The region 23' acts as a side gate which extends alongside the side wall 21 of the pillar 20. When a gate voltage is applied to the contact region 28G, the controlling field is applied by the side gate through its side wall 22 into the layer structure 3 so as to control its tunnel barrier configuration, in a manner previously described. The controlling field is applied substantially only through the side wall 22; no significant field is applied through the top surface 21 of the pillar structure. Although the region 23' bridges over the pillar, it is spaced from the pillars top surface 21 by the thickness of the source region 5 and overlying insulating layer 41, and thus no significant field is applied through the top surface. The described configuration has the advantage that because the gate field is applied through the side wall, the high electric field region between the gate and the drain is substantially reduced thereby improving the source-drain characteristics of the transistor.

It will be appreciated that the device described with reference to Figures 21 and 22 may utilise alternative multi-layer structures 3 in order to provide the pillar structure 20, in the manner described previously with reference to Figures 8 to 19, for example.

Furthermore, it will be understood that the side gated structure described with reference to Figure 21 may also be used in a memory device rather than a transistor, in which the drain region 2 is replaced by a polysilicon or like conducting memory node 10, with source and drain regions corresponding to regions 17, 18 previously described being formed in the device substrate.

In the structures previously described, it can be designed so that the electrons are transported mainly at the surface region of the pillar. In this configuration the operation becomes similar to the MOS transistor and not so much influenced by the lateral dimension of pillar. The devices can also be designed so that electrons are transported through both surface and centre regions of pillar, particularly in a pillar with small lateral dimensions

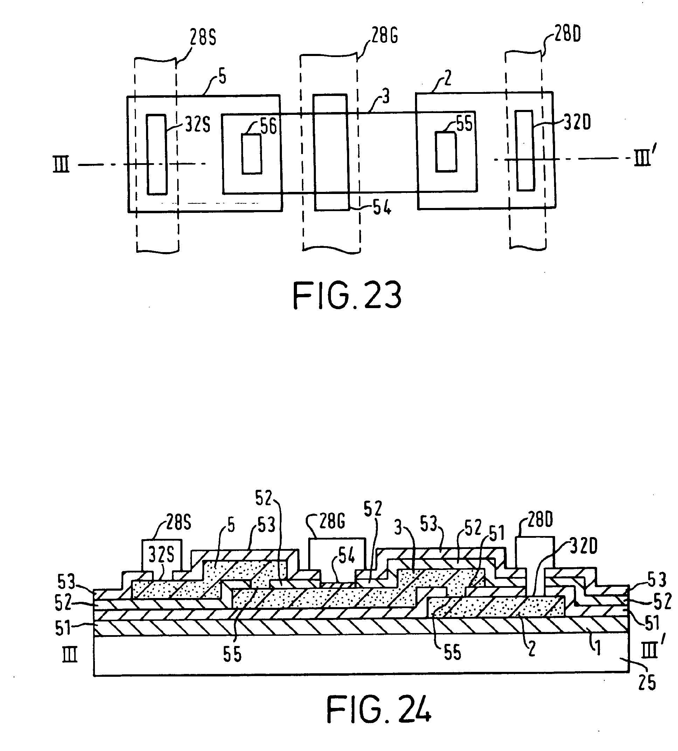

The structure described previously can be arranged laterally shown in Figure 23 in plan view and in the cross sectional view of Figure 24, taken along the line III-III' of Figure 23. The gate electrode 11G induces electric field into a multiple-tunnel junction to control the electron transport between a source and drain.

The gate is not overlapped with source and drain contact regions. In this structure, the gate region can be designed by lateral patterning and the fabrication process can be simplified.

A method of fabricating the device will now be described in more detail with reference to Figure 24. The starting materials comprise a silicon wafer 25 which is thermally oxidised at 1000°C to form a 600nm thick layer 1 of SiO₂ which acts as an insulating substrate. Then, a layer 2, which is used to produce the drain is formed on the SiO₂ layer 1. The layer 2 comprises 100nm thickness polysilicon deposited by LPCVD. A thin silicon dioxide layer of thickness of the order of 10nm is deposited on the surface of the layer 2. Arsenic ions are then implanted in the layer 2 to form an n⁺-doped conductive layer that can be used for the drain. The arsenic ions are implanted with a dosage of 3 × 10¹⁵cm⁻² at an energy of the order of 25 keV through the oxide layer (not shown). The 10nm oxide and silicon layer 2 are patterned by optical lithography and dry etching. Then, a silicon oxide layer 51 of thickness 60nm is deposited, and a contact window 55 is etched through the oxide layers 51 and 10nm and oxide in order to allow electrical connection to be made to the drain layer 2. The contact window 55 is formed by optical lithography and wet etching using 20:1 BHF solution.

Thereafter, a stack of the silicon and the silicon nitride layers are grown so as to form the multiple layer structure 3 that gives rise to the multiple tunnel junction, by the same method described before. The multiple layer 3 is patterned by optical lithography and dry etching.

Then, a silicon oxide layer 52 of thickness 60nm is deposited, and the contact window 56 is etched through the oxide layer 52 in order to allow electrical connection. The contact window 56 is formed by optical lithography and wet etching using 20:1 BHF solution.

Then, layer 5, which is used to produce the source, is formed. The layer 5 comprises 100nm thickness polysilicon deposited by LPCVD. A thin silicon dioxide layer of thickness of the order of 10nm is deposited on the surface of the layer 5. Arsenic ions are then implanted in the layer 5 to form an n⁺-doped conductive layer that can be used for the source. The arsenic ions are implanted with a dosage of 3 × 10¹⁵cm⁻² at an energy of the order of 25keV through the oxide layer (not shown). Then the 10nm oxide and the silicon layer 5 are patterned by optical lithography and dry etching.

A silicon oxide layer 53 of thickness 60nm is deposited, and the gate window 54 is etched through the oxide layers 53 and 52. The gate window 54 is formed by optical lithography and wet etching using 20:1 BHF solution. Then, a 10nm silicon dioxide layer 54 is formed by thermal oxidation.

Then, the contact window 32D is etched through the oxide layers 51, 52 and 53 in order to allow electrical connection to be made to'the drain layer 2. The contact window 32D is formed by optical lithography and wet etching using 20:1 BHF solution. At the same time, a contact window 32S is made to the source 5. Metallisation and patterning is then carried by the same method described with reference to Fig. 211, to complete the structure shown in Figure 23 and Figure 24.

It will be appreciated that the device described with reference to Figures 23 and 24 may utilise alternative multi-layer structures 3, in the manner described previously with reference to Figures 8 to 19, for example. Also, the drain 2 may be replaced by a memory node in order to provide a memory device rather than a transistor.

Many other modifications and variations within the scope of the invention will be apparent to those skilled in the art. For example, whilst in the described embodiments silicon nitride is used to provide the insulating layers of the multi-layer structure 3, silicon oxide layers could be used or other films of insulating material. Also, the n-type and p-type regions could be interchanged and varied in the type of dopant used. For example it would be possible to use a n-type source and drain (or memory node), with a p-type gate.

## Claims

1. A controllable conduction device comprising an upstanding pillar structure (20) having a side wall (22) and a top surface, the structure being formed of a plurality of conductive islands (34) of relatively conductive and non-conductive material that provide an energy band profile that comprises a dimensionally relatively wide (W) barrier component with a relatively low barrier height (b), and at least one relatively narrow (w) barrier component (8) with a relatively high barrier height (B), such that in a first condition, charge carrier flow can occur through the pillar structure and in a second condition the regions present a tunnel barrier configuration that inhibits charge carrier flow through the pillar structure, and a side gate structure (23) alongside the side wall of the pillar structure, configured to apply an electric field through the side wall into the pillar structure to control electrical conductivity therein.

2. A device according to claim 1 wherein the islands are distributed in an insulating matrix (35).

3. A device according to claim 1 or 2 wherein the islands (34) have a diameter of 3-10nm.

4. A device according to any preceding claim wherein the islands (34) comprise nano-crystals of semiconductor material.

5. A device according to any one of the preceding claims wherein the islands (34) are formed of a metal.

6. A device according to any preceding claim operable as a transistor, including source (5) and drain (2) regions to provide a source-drain charge carrier flow path through the pillar structure, and the side gate is operable to control charge carrier flow along the source-drain charge carrier flow path.

7. A device according to any one of the preceding claims operable as a memory, including a memory node (10) to receive charge carriers that pass along a path through the pillar structure, and the side gate is operable to control charge carrier flow along the path, for controlling the charge stored in the node.

8. A device according to claim 7 including a source-drain path having a conductivity dependent on the level of electrical charge stored in the node.

9. A device according to any preceding claim wherein said side gate structure comprises a Schottky gate.

10. A device according to any preceding claim wherein the side gate structure comprises a junction gate.

11. A device according to any preceding claim wherein the side gate is disposed alongside the side wall but does not overlie the top surface.

12. A device according to any one of the preceding claims wherein the side gate is formed of a region (23') which is disposed alongside the side wall and also forms a bridge over the pillar structure spaced from its top surface such that no significant controlling electrostatic field is applied by the region into the pillar structure from the bridge.

13. A device according to any preceding claim including a control electrode (285) extending over the entire top surface of the pillar structure.

14. A memory device comprising a pillar structure (20) formed of regions of relatively conductive and non-conductive material (6', 7') such that in a first condition, charge carrier flow can occur through the pillar structure and in a second condition the regions present a tunnel barrier configuration that inhibits charge carrier flow through the structure, a memory node (10) to receive charge carriers that pass along a path through the structure, and a control electrode (21) for supplying charge carriers to the path so as to pass through the structure to be stored at the node, wherein the regions of non-conductive material are configured so as to provide an energy band profile that comprises dimensionally relatively narrow barrier components (8") adjacent the memory node (10) and the control electrode (21)respectively, and a dimensionally relatively wide barrier component between the narrow barrier components, the barrier components being configured such as to provide non-volatile charge storage at the node (10).

15. A device according to claim 23 including a side gate to apply an electrostatic field to the pillar structure (20) through its side wall.

16. A controllable conduction device comprising a substrate (1), control elements (2, 5) spaced apart laterally on the substrate, a channel structure (3) electrically connected to and extending between the control elements, the channel structure being formed of regions of relatively conductive and non-conductive material such that in a first condition, charge carrier flow can occur through the structure and in a second condition the regions present a tunnel barrier configuration that inhibits charge carrier flow, and a gate region (28G) configured to apply an electric field into the channel structure to control electrical conductivity therein, the channel structure (3) being configured so as to lip under one of the control elements an lip over the other of the control elements on the substrate.

17. A device according to claim 25 wherein the control elements comprise source and drain regions (2, 5).

18. A device according to claim 25 wherein one of said control elements comprises a memory node.

19. A device according to claim 25 wherein the gate region is disposed between the control elements, overlying the channel structure.

20. A controllable conduction device comprising: a substrate (1), an upstanding structure comprising a barrier region (6₂, 7), a first overlying path region (6₁) that overlies the barrier region, an underlying path region (6₁) that underlies the barrier region (6₂, 7), the underlying path region (6₁) overlying the substrate (1), the upstanding structure having an upwardly extending side (22) and providing a generally vertical conduction path for charge carriers extending between the underlying and overlying layers, and gate (23) on the upwardly extending side of the upstanding structure for controlling charge carrier flow along the conduction path, the barrier region being formed of material which provides an internal electrostatic barrier potential to provide a barrier for inhibiting charge carrier flow along the generally vertical conduction path between the source and drain regions, the barrier height being configurable selectively in response to an external bias applied to the gate so that charge carriers can pass along the path between the source and drain regions, and a memory node (10) coupled to the said conduction path to be charged and discharged through said upstanding structure.
